(19) Europäisches Patentamt
European Patent Office
Office européen des brevets

(11) **EP 2 820 433 B1**

(12) **FASCICULE DE BREVET EUROPEEN**

(45) Date de publication et mention de la délivrance du brevet:
**09.01.2019 Bulletin 2019/02**

(21) Numéro de dépôt: **13707364.9**

(22) Date de dépôt: **28.02.2013**

(51) Int Cl.:
*G01R 21/133* (2006.01)     *G01R 31/327* (2006.01)
*H02J 13/00* (2006.01)

(86) Numéro de dépôt international:
**PCT/EP2013/054106**

(87) Numéro de publication internationale:
**WO 2013/127966 (06.09.2013 Gazette 2013/36)**

(54) **COMPTEUR D'ÉNERGIE ÉLECTRIQUE ET PROCÉDÉ DE DÉTECTION DE L'ÉTAT D'UN DISJONCTEUR D'UNE INSTALLATION RELIÉE A UN TEL COMPTEUR**

ELEKTRIZITÄTSZÄHLER UND VERFAHREN ZUR FESTSTELLUNG DES ZUSTANDES EINES SCHUTZSCHALTERS EINER MIT DIESEM ZÄHLER VERBUNDENEN VORRICHTUNG

ELECTRICAL ENERGY METER AND METHOD FOR DETECTING THE STATE OF A CIRCUIT BREAKER OF AN APPARATUS CONNECTED TO SAID METER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.02.2012 FR 1251839**

(43) Date de publication de la demande:
**07.01.2015 Bulletin 2015/02**

(73) Titulaire: **Sagemcom Energy & Telecom SAS 92500 Rueil-Malmaison (FR)**

(72) Inventeurs:
• **WEBER, Patrick**
  **F-92500 Rueil Malmaison (FR)**

• **TEBOULLE, Henri**
  **F-92500 Rueil Malmaison (FR)**
• **NOIRET, Sébastien**
  **F-92500 Rueil Malmaison (FR)**

(74) Mandataire: **Lavialle, Bruno François Stéphane et al**
**Cabinet Boettcher**
**16, rue Médéric**
**75017 Paris (FR)**

(56) Documents cités:
**WO-A1-2010/149921     FR-A1- 2 953 983
JP-A- 2007 003 407     US-A- 5 369 356
US-A- 5 488 565     US-A- 5 627 717**

EP 2 820 433 B1

## Description

L'invention a pour objet un compteur d'énergie électrique pour mesurer un courant de phase circulant sur un conducteur de phase et consommé sous une tension de phase par une installation de destination située en aval du compteur.

ARRIERE PLAN DE L'INVENTION

La plupart des compteurs d'énergie électrique modernes comportent des relais de coupure que le distributeur d'énergie peut commander à distance. Ces relais de coupure permettent notamment au distributeur de couper ou de rétablir l'alimentation d'une installation électrique en énergie électrique provenant d'un réseau de distribution (en cas de résiliation d'un abonnement d'un utilisateur de l'installation électrique ou en cas d'emménagement de l'utilisateur dans un nouveau logement par exemple), sans qu'il soit nécessaire d'envoyer du personnel sur place.

Il est impératif, pour des raisons de sécurité, que le distributeur connaisse l'état réel (ouvert ou fermé) du relais de coupure. En particulier, lorsque l'utilisateur connecte une autre source d'alimentation à l'installation électrique de son domicile, par exemple un groupe électrogène de secours pour pallier à une défaillance du réseau de distribution, le relais de coupure doit impérativement être ouvert. Si ce n'était pas le cas, la source d'alimentation et le réseau de distribution seraient court-circuités, ce qui risquerait d'endommager l'installation électrique et de provoquer un incendie.

Ces relais de coupure sont généralement des relais bistables, dont les contacts restent en position lorsque les relais ne sont plus alimentés. Un des inconvénients majeurs de ce type de relais est qu'ils peuvent s'ouvrir ou se refermer intempestivement à cause de sollicitations accidentelles mécaniques (choc, etc.) ou électromagnétiques (déplacement d'un aimant à proximité du compteur, création d'un arc électrique, etc.). Ainsi, l'état réel du relais de coupure peut être différent de l'état commandé par le distributeur d'énergie.

Pour connaître l'état réel du relais de coupure, une solution envisageable consisterait à utiliser une mesure fournie par un capteur de courant équipant le compteur électrique, destiné à mesurer la consommation de l'utilisateur. On déduirait alors du courant mesuré l'état du relais. Généralement, ce type de capteur est situé en amont (côté réseau de distribution) du relais de coupure. Mais, lorsque la charge en aval (côté installation électrique) est très élevée (par exemple, lorsqu'un disjoncteur de l'installation est ouvert), le courant traversant le capteur est presque nul, même si le relais de coupure est fermé, de sorte que le courant traversant le capteur ne peut être utilisé pour détecter l'état du relais.

Outre l'état réel du relais de coupure, il peut être intéressant de connaître avec une bonne fiabilité l'état réel du disjoncteur de l'installation lorsque le relais de coupure est ouvert. En effet, dans certains pays tels l'Espagne, une ouverture du relais de coupure peut être commandée en cas de détection d'une surpuissance. Le relais de coupure reste alors ouvert jusqu'à ce que l'utilisateur ouvre manuellement le disjoncteur de l'installation. Lorsque cette ouverture est détectée, une fermeture du relais de coupure est commandée. Or, lorsque le relais de coupure est ouvert, un bruit parasite, provenant d'équipements de l'installation, peut se propager dans le compteur électrique par un effet d'antenne. Ce bruit parasite perturbe des mesures réalisées dans le compteur d'énergie électrique et visant à détecter si le disjoncteur est ouvert ou fermé. Les documents WO2010/149921 et US5488565 divulguent des compteurs d'énergie électrique.

OBJET DE L'INVENTION

L'invention a pour objet de détecter l'état ouvert ou fermé d'un relais de coupure d'un compteur électrique d'une installation en fournissant une information fiable même lorsque la charge en aval du compteur est élevée, et/ou de détecter avec une bonne fiabilité si un disjoncteur de l'installation est ouvert ou fermé lorsque le relais de coupure est ouvert.

RESUME DE L'INVENTION

En vue de la réalisation de ce but, on propose un compteur d'énergie électrique pour mesurer un courant de phase circulant sur un conducteur de phase et consommé sous une tension de phase par une installation de destination située en aval du compteur. Le compteur comporte un étage de mesure comprenant un capteur de courant de phase monté en série avec un relais de coupure, deux impédances séries de mesure montées en parallèle avec le capteur et le relais, des moyens de mesure pour mesurer le potentiel électrique entre les impédances de mesure. Les deux impédances de mesure sont positionnées de manière à ce qu'une première impédance soit connectée au conducteur de phase en amont du capteur et du relais et la seconde impédance soit connectée au conducteur de phase en aval du capteur et du relais. L'étage de mesure comporte en outre une source de tension connectée en série avec les impédances de mesure.

La source de tension génère une tension au niveau des moyens de mesure, même lorsque la charge en aval du compteur est très élevée. Cette tension est différente selon l'état (ouvert ou fermé) du relais de coupure. Elle permet donc d'obtenir une indication crédible de l'état du relais, basée sur un paramètre physique caractérisant l'état du relais.

On propose de plus un procédé pour détecter si le disjoncteur de l'installation de destination est dans un état ouvert ou fermé en utilisant un compteur d'énergie électrique tel que celui précédemment décrit. Le procédé comporte :

- une étape de mesure, au cours de laquelle on mesure le potentiel électrique entre les impédances de mesure de manière à obtenir un signal de mesure numérique échantillonné représentatif de ce potentiel électrique ;
- une première étape de traitement, au cours de laquelle on estime une composante continue du signal de mesure sur des intervalles de durée prédéterminée correspondant à un certain nombre d'échantillons du signal de mesure ;
- une deuxième étape de traitement, au cours de laquelle on estime une valeur efficace du signal de mesure sur les intervalles ;
- une troisième étape de traitement, au cours de laquelle on estime une valeur efficace hors composante continue de ce signal de mesure sur les intervalles ;
- une quatrième étape de traitement, au cours de laquelle on détermine si le disjoncteur est ouvert ou fermé à partir de la valeur efficace hors composante continue du signal de mesure.

Dans le cas où un bruit parasite par effet d'antenne est présent, la valeur efficace hors composante continue du signal de mesure représentatif du potentiel électrique entre les impédances de mesure est moins importante lorsque le disjoncteur est ouvert, car le bruit parasite généré par l'effet d'antenne est moins important. On peut donc détecter si le disjoncteur est ouvert ou fermé en traitant cette valeur efficace hors composante continue.

L'invention sera mieux comprise à la lumière de la description qui suit d'un mode de mise en oeuvre particulier non limitatif de l'invention.

BREVE DESCRIPTION DES DESSINS

Il sera fait référence aux dessins annexés, parmi lesquels :

- la figure 1 représente schématiquement un compteur d'énergie électrique de l'invention,
- la figure 2 représente des impédances de mesure et des moyens de mesure d'un compteur de l'invention.

DESCRIPTION DETAILLEE DE L'INVENTION

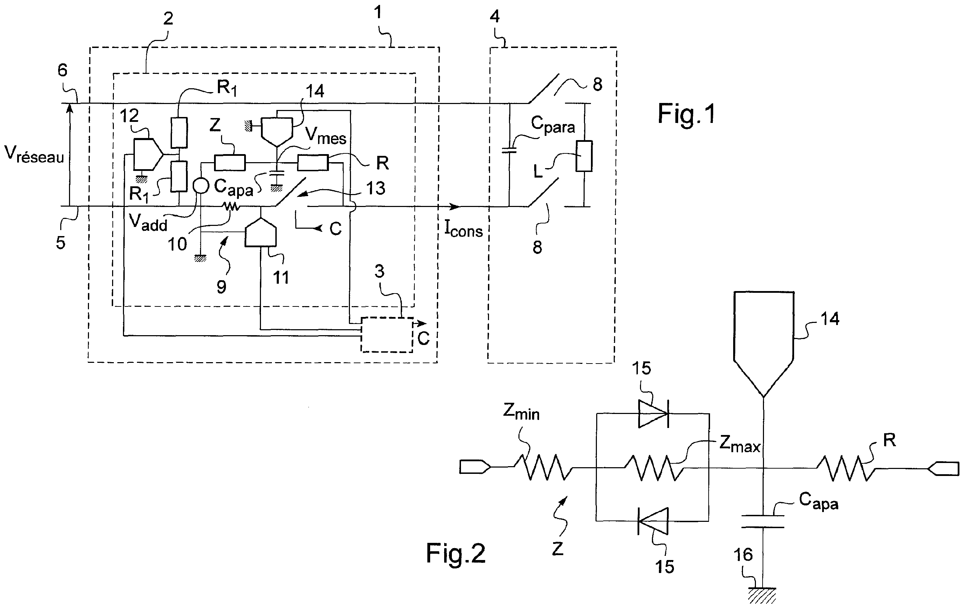

Un compteur d'énergie électrique 1 de l'invention comporte un étage de mesure 2 et une unité de traitement 3, visibles à la figure 1. Cet étage de mesure 2 est utilisé pour mesurer une puissance électrique consommée Pcons par une installation de destination 4. Cette puissance électrique Pcons, fournie par un distributeur et provenant d'un réseau de distribution électrique, est ici acheminée vers l'installation de destination 4 par un conducteur de phase 5 et un conducteur de neutre 6, entre lesquels le réseau électrique génère une tension Vréseau. L'entrée de l'installation 4 est modélisée par une charge dont l'impédance L dépend des équipements électriques de l'installation 4, de leur état (marche ou arrêt), et de l'état d'un disjoncteur 8 (ouvert ou fermé) de l'installation 4 accessible à un utilisateur.

Pour mesurer un courant consommé Icons par l'installation 4, l'étage de mesure 2 du compteur 1 comporte un capteur de courant 9 à shunt. Le capteur de courant 9 à shunt comporte un shunt 10 de résistance connue et un premier voltmètre 11 branché aux bornes du shunt 10 pour mesurer la tension à ses bornes. Le premier voltmètre 11 est connecté à l'unité de traitement 3, qui déduit le courant consommé Icons de la valeur de la tension mesurée par le premier voltmètre 11. L'étage de mesure 2 comporte en outre deux résistances série R1, R2 connectés entre le conducteur de phase 5 et le conducteur de neutre 6 en amont du shunt 10, c'est-à-dire du côté réseau de distribution, ainsi qu'un deuxième voltmètre 12 mesurant le potentiel entre les deux résistances R1, R2. Le deuxième voltmètre 12 est connecté à l'unité de traitement 3, qui déduit la puissance consommée Pcons par l'installation 4 de la tension mesurée par le deuxième voltmètre 12 et du courant consommé Icons par l'installation 4.

L'étage de mesure 2 comporte aussi un relais de coupure bistable 13 que le distributeur d'énergie peut commander pour couper la distribution vers l'installation 4, ou au contraire, la rétablir. Le relais 13 est contrôlé à distance par le distributeur via l'unité de traitement 3 qui commande le relais de coupure 13 en lui envoyant, via le réseau de distribution, une commande C d'ouverture ou de fermeture.

L'étage de mesure 2 comporte en outre une première impédance de mesure Z et une seconde impédance de mesure R en série, connectées en parallèle du capteur de courant 9 et du relais de coupure 13, ainsi qu'une source de tension continue additionnelle Vadd et un troisième voltmètre 14 mesurant le potentiel Vmes entre les deux impédances de mesure Z, R et connecté à l'unité de traitement 3. La première impédance de mesure Z est reliée au conducteur de phase 5 en amont du capteur 9 et du relais 13 (c'est-à-dire côté réseau de distribution), alors que la seconde impédance de mesure R est reliée au conducteur de phase 5 du côté aval du compteur 1 (c'est-à-dire côté installation de destination 4). La source de tension additionnelle Vadd est connectée entre la première impédance de mesure Z et le conducteur de phase 5.

La source de tension additionnelle Vadd délivre une tension faible (Vadd = 1,5 Volt par exemple) au regard de l'amplitude de la tension du réseau électrique Vréseau entre le conducteur de phase et de neutre (tension alternative de 230 Volts, 50 Hz). Cette source de tension additionnelle Vadd génère une tension Vmes au niveau du troisième voltmètre 14, même quand l'impédance L de la charge est très élevée, par exemple lorsque le disjoncteur 8 est ouvert. La valeur de cette tension Vmes est différente selon la valeur de l'impédance L, et selon que le relais de coupure est ouvert ou fermé. L'unité de traitement déduit de la valeur de Vmes l'état du relais de coupure 13.

Lorsque l'impédance L est relativement faible et que le relais de coupure 13 est ouvert, le troisième voltmètre 14 mesure une tension alternative issue de la tension du réseau Vréseau, et divisée par un diviseur de tension formé par les impédances Z, R, L :

$$Vmes = \frac{Z}{Z + R + L} Vréseau.$$

Lorsque l'impédance L est relativement faible et que le relais de coupure 13 est fermé, le troisième voltmètre 14 mesure une tension continue issue de la tension additionnelle Vadd, et divisée par un diviseur de tension formé par les impédances Z et R :

$$Vmes = \frac{R}{Z + R} Vadd.$$

Lorsque l'impédance L est très élevée (par exemple, lorsque le disjoncteur 8 est ouvert) et que le relais de coupure 13 est ouvert, le troisième voltmètre 14 mesure une tension continue égale à la tension additionnelle :

$$Vmes = Vadd.$$

Lorsque l'impédance L est très élevée et que le relais de coupure 13 est fermé, le troisième voltmètre 14 mesure une tension continue issue de la tension additionnelle Vadd, et divisée par un diviseur de tension formé par les impédances Z et R :

$$Vmes = \frac{R}{Z + R} Vadd$$

Ainsi, la tension mesurée Vmes par le troisième voltmètre 14 est, selon la valeur de la charge L et l'état du relais, soit issue de la tension Vadd générée par la source de tension additionnelle, soit issue de la tension du réseau Vréseau.

Il est aussi possible d'utiliser la valeur de la tension mesurée Vmes pour détecter, lorsque le relais de coupure 13 est ouvert, une manoeuvre du disjoncteur 8 (ouverture ou fermeture) réalisée par l'utilisateur. Cette détection permet de commander la fermeture du relais de coupure 13 en fonction de la manoeuvre du disjoncteur. Comme cela a été vu précédemment, lorsque l'impédance L est relativement faible (ce qui implique que le disjoncteur 8 soit fermé) et que le relais de coupure 13 est ouvert, le troisième voltmètre 14 mesure :

$$Vmes = \frac{Z}{Z + R + L} Vréseau.$$

Lorsque l'utilisateur va ouvrir le disjoncteur 8, la charge L va augmenter progressivement, ce qui va modifier la valeur Vmes. L'unité de traitement 3, connectée au troisième voltmètre 14, va donc pouvoir détecter l'ouverture du disjoncteur 8 (et de la même façon, sa fermeture). Pour que la modification de l'impédance L conduise à une évolution significative de la valeur Vmes, il faut que l'impédance L ne soit pas négligeable devant les valeurs des impédances Z et R. On choisira donc pour Z+R une valeur proche de L. Dans cette configuration, il est possible que des pertes en amont du disjoncteur 8, dues par exemple à une capacité parasite Cpara entre les conducteurs 5 et 6, augmentent la valeur de l'impédance de charge L pour la porter à une impédance supérieure L'. On voit que dans ce cas, il est avantageux de choisir une valeur de Z+R proche de L'. On choisira donc avantageusement des valeurs de R et Z tels que Z+R ≤ L' et Z+R ≥ L.

Pour éviter que la plage de valeurs que doit mesurer le troisième voltmètre 14 ne soit trop importante, on prévoit une impédance Z non linéaire (visible à la figure 2), dont la valeur dépend de la tension à ses bornes. Z est constituée d'une résistance Zmin en série avec une résistance Zmax, et de deux diodes 15 montées tête-bêche et en parallèle avec Zmax. Par tête-bêche, on entend que les diodes sont en parallèle l'une avec l'autre et que la cathode de chaque diode 15 est connectée à l'anode de l'autre diode. La tension de seuil des diodes est de 0,6 Volt. On choisit Zmin = 1 kilo-ohm, et Zmax = 100 kilo-ohms. La résistance R, quant à elle, est de valeur fixe : R = 100 kilo-ohms.

Lorsque la tension aux bornes de Z est élevée, c'est-à-dire lorsque la tension est issue de la tension alternative du réseau Vréseau, l'une au moins des deux diodes 15 est passante, selon l'alternance positive ou négative de la tension Vréseau. Ainsi, l'impédance Z a pour valeur de résistance Z = Z min = 1 kilo-ohm.

Lorsque la tension aux bornes de Z est faible, c'est-à-dire lorsque la tension Vmes est issue de la tension additionnelle Vadd, les deux diodes sont bloquées et l'impédance Z a pour valeur de résistance :

$$Z = Z \ min + Z \ max = 101 \ kilo\text{-}ohms.$$

Ainsi, lorsque l'impédance L est relativement faible et que le relais de coupure est ouvert, on mesure une tension Vmes :

$$Vmes \approx \frac{1}{100} Vréseau$$

Ici, la valeur mesurée Vmes est proche de la valeur de la tension additionnelle Vadd.

Dans les autres cas, on mesure aussi des valeurs Vmes proches de la tension additionnelle Vadd. On a donc considérablement réduit la plage de mesure du voltmètre 14.

La non-linéarité de l'impédance Z a pour inconvénient de produire des harmoniques en entrée du troisième voltmètre 14 lorsque la tension mesurée Vmes est issue de la tension du réseau Vréseau. Pour supprimer ces harmoniques, on prévoit d'ajouter une capacité de filtrage Capa entre Z et R. La capacité Capa a une de ses armatures connectées entre Z et R, et une autre à une masse électrique 17. On crée donc un filtre de type « RC » restituant uniquement la fréquence f de la tension Vréseau.

On décrit maintenant le procédé de l'invention, destiné à détecter, lorsque le relais de coupure 13 est ouvert, si le disjoncteur 8 de l'installation 4 est ouvert ou fermé.

On rappelle que, lorsque le relais de coupure 13 est ouvert, un bruit parasite provenant d'équipements électriques de l'installation 4 peut se propager par effet d'antenne dans le compteur électrique. Le bruit parasite est généralement un bruit à une fréquence fo = 50 Hz comprenant en outre un certain niveau d'harmoniques de la fréquence fo.

Le procédé de l'invention comporte tout d'abord une étape de mesure, au cours de laquelle on mesure le potentiel électrique entre les impédances de mesure Z, R, en utilisant le troisième voltmètre 14. On obtient alors un signal de mesure numérique échantillonné représentatif de ce potentiel électrique. On appelle $V_k$ les échantillons de ce signal de mesure, k étant un entier positif. La fréquence d'échantillonnage fe est ici égale à 400 Hz, ce qui signifie que deux échantillons successifs $V_k$ et $V_{k+1}$ à deux instants séparés par une période Te = 1/fe. On divise l'ensemble de ces échantillons en intervalles réguliers comprenant ici chacun cent échantillons : chaque intervalle a donc ici une durée de 250 millisecondes.

Le procédé de l'invention comporte ensuite une première étape de traitement, au cours de laquelle on estime, pour chaque intervalle régulier de cent échantillons $V_k$, une composante continue Uc du signal de mesure, en utilisant la formule :

$$Uc = \frac{1}{100} \cdot \sum_{k=0}^{99} V_k$$

Le procédé de l'invention comporte ensuite une deuxième étape de traitement au cours de laquelle on estime, pour chaque intervalle régulier, une valeur efficace $U_{eff}$ du signal de mesure, en utilisant la formule :

$$Ueff = \sqrt{\frac{1}{100} \cdot \sum_{k=0}^{99} V^2{}_k}$$

Le procédé de l'invention comporte ensuite une troisième étape de traitement au cours de laquelle on estime, pour chaque intervalle régulier, une valeur efficace hors composante continue U du signal de mesure, en utilisant la formule :

$$U = \sqrt{U_{eff}^2 - U_c^2}$$

La valeur efficace hors composante continue U est donc représentative uniquement des différentes composantes fréquentielles du potentiel électrique mesuré au niveau du troisième voltmètre 14, et donc du bruit parasite propagé par l'effet d'antenne, qui est plus important lorsque le disjoncteur 8 est ouvert.

Le procédé de l'invention comporte enfin une quatrième étape de traitement, au cours de laquelle on détermine si le disjoncteur 8 est ouvert ou fermé à partir de la valeur efficace hors composante continue U.

On note ici que le procédé de l'invention n'est mis en oeuvre, suite à une ouverture du relais de coupure 13, qu'après une certaine durée préprogrammée et reprogrammable, par exemple égale à trois secondes.

Au cours de la quatrième étape de traitement, et conformément à un premier mode de réalisation du procédé de l'invention, on considère, à un certain moment correspondant temporellement à un certain intervalle N du signal de mesure, que le disjoncteur est ouvert si, pour K variant de 1 à M, on a :

$$\frac{U_{N+K+1}}{U_N} < (100 - X)\%,$$

K et M étant des entiers positifs, X étant un nombre positif inférieur ou égal à cent, $U_{N+K+1}$ et $U_N$ sont les valeurs efficaces hors composante continue du signal de mesure sur les intervalles N+K+1 et N. On utilise par exemple M = 8 et X = 10.

On constate ainsi qu'après l'intervalle N, le niveau de bruit a été inférieur d'un certain pourcentage au niveau de bruit présent lors de l'intervalle N, ce qui signifie que le disjoncteur 8 a été ouvert au moment correspondant à l'intervalle N.

Au cours de la quatrième étape de traitement, et conformément à un second mode de réalisation du procédé de l'invention, on considère, à un certain moment correspondant temporellement à un certain intervalle N du signal de mesure, que le disjoncteur est ouvert si, pour K variant de 1 à M, on a :

$$U_N - U_{N+K+1} > Y,$$

K, M étant des entiers positifs, Y étant une valeur de tension prédéterminée, et $U_{N+K+1}$ et $U_N$ étant les valeurs efficaces hors composante continue du signal de mesure sur les intervalles N+K+1 et N. On utilise par exemple M = 8 et Y = 0,073 Volt.

Avantageusement, on prévoit de remplacer la quatrième étape du procédé de l'invention par une cinquième étape différente de la quatrième, dans le cas où le bruit parasite est trop faible pour que l'estimation de la valeur efficace hors composante continue U soit pertinente pour déterminer si le disjoncteur est ouvert ou fermé.

Cette cinquième étape peut être mise en oeuvre de manière continue, c'est-à-dire qu'on traite en permanence les échantillons de mesure, pour pouvoir estimer si le disjoncteur est ouvert ou fermé à la fin de chaque intervalle.

Ainsi, si la valeur efficace hors composante continue estimée sur un certain nombre d'intervalles est inférieure à un premier seuil prédéterminé S1, on n'effectue pas la quatrième étape de traitement mais on la remplace par une cinquième étape de traitement au cours de laquelle on considère que le disjoncteur est ouvert si, pour un intervalle donné, la composante continue Uc du signal de mesure est inférieure à deuxième seuil prédéterminé S2 de tension.

On considère donc que le disjoncteur est ouvert si :

$$Uc = \frac{1}{100} \cdot \sum_{k=0}^{99} V_k < S2$$

Alternativement, on considèrera dans cette cinquième étape que le disjoncteur est ouvert si, pour un certain intervalle :

$$\frac{Max(V_k) + Min(V_k)}{2} < S3$$

où Max(Vk) et Min(Vk) sont respectivement les valeurs maximale et minimale des échantillons Vk sur l'intervalle en question, et où S3 est un troisième seuil prédéterminé de tension.

De manière optionnelle, on peut aussi prévoir de ne pas activer la cinquième étape de traitement si la valeur efficace du signal de mesure $U_{eff}$ est supérieure à un quatrième seuil prédéterminé S4, ce qui permet notamment de ne pas mettre en oeuvre le procédé de l'invention sur un signal de mesure susceptible de saturer un convertisseur analogique-numérique du troisième voltmètre 14.

Enfin, et de manière à nouveau optionnelle, dans le cas où le relais de coupure a été ouvert suite à une détection d'une surpuissance, on peut prévoir d'ajouter une temporisation programmable (ayant typiquement une durée de temporisation de 3 minutes), suite à laquelle on referme le relais de coupure si la puissance est redevenue normale pendant la durée de la temporisation, même si une ouverture du disjoncteur de l'installation n'a pas été détectée.

L'invention n'est pas limitée aux modes de réalisation particuliers qui viennent d'être décrits, mais, bien au contraire, couvre toute variante entrant dans le cadre de l'invention telle que définie par les revendications.

L'ensemble des valeurs numériques utilisées ne sont fournies qu'à titre d'exemple, pour illustrer l'invention.

Bien que l'on ait choisi un compteur d'énergie électrique monophasé pour illustrer l'invention, celle-ci est applicable à un compteur polyphasé, triphasé par exemple.

Bien que l'on ait choisi d'utiliser un capteur à shunt pour mesurer le courant consommé par l'installation de destination, il est possible de prévoir un capteur différent, de type capteur à effet Hall ou à transformateur de courant par exemple.

## Revendications

1. Compteur d'énergie électrique (1) pour mesurer un courant de phase (Icons) circulant sur un conducteur de phase (5) et consommé sous une tension de phase (Vréseau) par une installation de destination (4) située en aval du compteur, le compteur comportant un étage de mesure (2) comprenant un capteur de courant (9) de phase monté en série avec un relais de coupure (13), deux impédances séries de mesure (Z, R) montées en parallèle avec le capteur (9) et le relais (13), des moyens de mesure (14) pour mesurer le potentiel électrique entre les impédances de mesure (Z, R), les deux impédances de mesure (Z, R) étant positionnées de manière à ce qu'une première impédance (Z) soit connectée au conducteur de phase (5) en amont du capteur (9) et du relais (13) et la seconde impédance (R) soit connectée au conducteur de phase (5) en aval du capteur (9) et du relais (13), **caractérisé en ce que** l'étage de mesure (2) comporte en outre une source de tension additionnelle (Vadd) connectée en série avec les impédances de mesure (Z, R).

2. Compteur d'énergie électrique (1) selon la revendication 1, dans lequel la source de tension additionnelle (Vadd) est positionnée entre la première impédance de mesure (Z) et le conducteur de phase (5) en amont du capteur (9) et du relais (13).

3. Compteur d'énergie électrique (1) selon la revendication 1, dans lequel la première impédance (Z) de mesure est non-linéaire.

4. Compteur d'énergie électrique (1) selon la revendication 3, dans lequel la première impédance de mesure (Z) comporte une première résistance (Zmax) et une première diode (15) montée en parallèle de cette première résistance (Zmax).

5. Compteur d'énergie électrique (1) selon la revendication 4, dans lequel la première impédance de mesure comporte en outre une seconde diode (15) montée tête-bêche avec la première diode (15).

6. Compteur d'énergie électrique (1) selon la revendication 4, dans lequel la première impédance de mesure (Z) comporte en outre une seconde résistance (Zmin) montée en série avec la première résistance (Zmax).

7. Compteur d'énergie électrique selon la revendication 1, dans lequel l'étage de mesure (2) comporte en outre un condensateur (Capa) dont une armature est connectée aux deux impédances de mesures (Z, R) entre celles-ci et une autre armature est reliée à une masse électrique (16).

8. Compteur d'énergie électrique selon la revendication 1, dans lequel l'étage de mesure (2) comporte en outre des moyens de traitement (3) agencés pour détecter, en fonction de mesures fournies par les moyens de mesure (14), l'ouverture ou la fermeture d'un disjoncteur (8) de l'installation de destination (4) lorsque le relais de coupure (13) est ouvert.

9. Procédé pour détecter si le disjoncteur (8) de l'installation de destination (4) est dans un état ouvert ou fermé en utilisant un compteur d'énergie électrique selon l'une des revendications précédentes, le procédé comportant :

   - une étape de mesure, au cours de laquelle on mesure le potentiel électrique entre les impédances de mesure (Z, R) de manière à obtenir un signal de mesure numérique échantillonné représentatif de ce potentiel électrique ;
   - une première étape de traitement, au cours de laquelle on estime une composante continue ($U_c$) du signal de mesure sur des intervalles de durée prédéterminée correspondant à un certain nombre d'échantillons du signal de mesure ;
   - une deuxième étape de traitement, au cours de laquelle on estime une valeur efficace ($U_{eff}$) du signal de mesure sur les intervalles ;
   - une troisième étape de traitement, au cours de laquelle on estime une valeur efficace hors composante continue (U) de ce signal de mesure sur les intervalles ;
   - une quatrième étape de traitement, au cours de laquelle on détermine si le disjoncteur est ouvert ou fermé à partir de la valeur efficace hors composante continue (U) du signal de mesure.

10. Procédé selon la revendication 9, dans lequel on détermine si le disjoncteur est ouvert ou fermé, à un certain moment correspondant à un certain intervalle, en comparant la valeur efficace hors composante continue du signal de mesure sur le certain intervalle avec les valeurs efficaces hors composante continue estimées dans plusieurs intervalles successifs succédant au certain intervalle.

11. Procédé selon la revendication 10, dans lequel on considère que le disjoncteur (8) est ouvert au moment d'un intervalle N si, pour K = 1 à M,

$$\frac{U_{N+K+1}}{U_N} < (100 - X)\%,$$

où K et M sont des entiers positifs, X est un nombre positif inférieur ou égal à cent, et où $U_{N+K+1}$ et $U_N$ sont les valeurs efficaces hors composante continue du signal de mesure sur les intervalles N+K+1 et N.

12. Procédé selon la revendication 10, dans lequel on considère que le disjoncteur est ouvert au moment de l'intervalle N si, pour K = 1 à M,

$$U_N - U_{N+K+1} > Y$$

où K et M sont des entiers positifs, Y est une valeur de tension prédéterminée, et où $U_{N+K+1}$ et $U_N$ sont les valeurs efficaces hors composante continue du signal de mesure sur les intervalles N+K+1 et N.

13. Procédé selon la revendication 9, dans lequel, si la valeur efficace hors composante continue estimée sur un certain nombre d'intervalles est inférieure à un premier seuil prédéterminé (S1), on remplace la quatrième étape de traitement par une cinquième étape de traitement au cours de laquelle on considère que le disjoncteur est ouvert si, pour un intervalle donné, la composante continue du signal de mesure est inférieure à deuxième seuil prédéterminé (S2).

14. Procédé selon la revendication 9, dans lequel, si la valeur efficace hors composante continue estimée sur un certain nombre d'intervalles est inférieure à un premier seuil prédéterminé (S1), on remplace la quatrième étape de traitement par une cinquième étape de traitement au cours de laquelle on considère que le disjoncteur est ouvert si, pour un certain intervalle,

$$\frac{Max(V_k) + Min(V_k)}{2} < S3$$

où k est un entier positif, où les valeurs $V_k$ sont les valeurs des échantillons du signal de mesure dans le certain intervalle, et où S3 est un troisième seuil prédéterminé.

15. Procédé selon l'une des revendications 13 ou 14, dans laquelle on n'active pas la cinquième étape de traitement si la valeur efficace du signal de mesure est supérieure à un quatrième seuil prédéterminé (S4).

16. Procédé selon l'une des revendications 9 à 15, dans lequel, dans le cas où le relais de coupure (13) a été ouvert suite à une détection d'une surpuissance, le relais de coupure est refermé après une certaine durée de temporisation programmable au cours de laquelle la surpuissance n'est plus détectée, même si une ouverture du disjoncteur de l'installation n'a pas été détectée.

**Patentansprüche**

1. Stromzähler (1) zum Messen eines Phasenstroms (Icons), der auf einem Phasenleiter (5) fließt und unter einer Phasenspannung (Vréseau) von einer Zielanlage (4), die sich stromabwärts des Zählers befindet, verbraucht wird, wobei der Zähler eine Messstufe (2) umfasst, die einen Phasenstromsensor (9) enthält, der in Reihe mit einem Trennrelais (13) geschaltet ist, zwei Messreihenimpedanzen (Z, R), die parallel zum Sensor (9) und zum Relais (13) geschaltet sind, Messmittel (14) zum Messen des elektrischen Potentials zwischen den Messimpedanzen (Z, R), wobei die beiden Messimpedanzen (Z, R) derart positioniert sind, dass eine erste Impedanz (Z) an den Phasenleiter (5) stromaufwärts des Sensors (9) und des Relais (13) angeschlossen ist und die zweite Impedanz (R) an den Phasenleiter (5) stromabwärts des Sensors (9) und des Relais (13) angeschlossen ist, **dadurch gekennzeichnet, dass** die Messstufe (2) ferner eine zusätzliche Spannungsquelle (Vadd) umfasst, die in Reihe mit den Messimpedanzen (Z, R) geschaltet ist.

2. Stromzähler (1) nach Anspruch 1, bei dem die zusätzliche Spannungsquelle (Vadd) zwischen der ersten Messimpedanz (Z) und dem Phasenleiter (5) stromaufwärts des Sensors (9) und des Relais (13) positioniert ist.

3. Stromzähler (1) nach Anspruch 1, bei dem die erste Messimpedanz (Z) nichtlinear ist.

4. Stromzähler (1) nach Anspruch 3, bei dem die erste Messimpedanz (Z) einen ersten Widerstand (Zmax) und eine erste Diode (15) umfasst, die parallel zu diesem ersten Widerstand (Zmax) geschaltet ist.

5. Stromzähler (1) nach Anspruch 4, bei dem die erste Messimpedanz ferner eine zweite Diode (15) umfasst, die antiparallel zur ersten Diode (15) geschaltet ist.

6. Stromzähler (1) nach Anspruch 4, bei dem die erste Messimpedanz (Z) ferner einen zweiten Widerstand (Zmin) umfasst, der in Reihe mit dem ersten Widerstand (Zmax) geschaltet ist.

7. Stromzähler (1) nach Anspruch 1, bei dem die Messstufe (2) ferner einen Kondensator (Capa) umfasst, von dem ein Anker an die beiden Messimpedanzen (Z, R) zwischen denselben angeschlossen ist und ein weiterer Anker mit einer elektrischen Masse (16) verbunden ist.

8. Stromzähler nach Anspruch 1, bei dem die Messstufe (2) ferner Verarbeitungsmittel (3) umfasst, die so ausgebildet sind, dass sie in Abhängigkeit von Messungen, die von den Messmitteln (14) geliefert werden, das Öffnen oder das Schließen eines Schutzschalters (8) der Zielanlage (4) erfassen, wenn das Trennrelais (13) geöffnet ist.

9. Verfahren zum Erfassen, ob der Schutzschalter (8) der Zielanlage (4) in einem geöffneten oder geschlossenen Zustand ist, indem ein Stromzähler nach einem der vorhergehenden Ansprüche verwendet wird, wobei das Verfahren umfasst:

   - einen Messschritt, während dessen man das elektrische Potential zwischen den Messimpedanzen (Z, R) misst, um ein abgetastetes digitales Messsignal zu erhalten, das repräsentativ für dieses elektrische Potential ist;
   - einen ersten Verarbeitungsschritt, während dessen man einen Gleichanteil ($U_c$) des Messsignals über Intervalle mit vorbestimmter Dauer schätzt, die einer bestimmten Anzahl von Abtastungen des Messsignals entsprechen;
- einen zweiten Verarbeitungsschritt, während dessen man den Effektivwert ($U_{eff}$) des Messsignals über die Intervalle schätzt;
- einen dritten Verarbeitungsschritt, während dessen man einen Effektivwert (U) ohne Gleichanteil dieses Messsignals über die Intervalle schätzt;
- einen vierten Verarbeitungsschritt, während dessen man anhand des Effektivwertes (U) ohne Gleichanteil des Messsignals bestimmt, ob der Schutzschalter geöffnet oder geschlossen ist.

10. Verfahren nach Anspruch 9, bei dem man bestimmt, ob der Schutzschalter zu einem bestimmten Zeitpunkt, der einem bestimmten Intervall entspricht, geöffnet oder geschlossen ist, indem man den Effektivwert ohne Gleichanteil des Messsignals über das bestimmte Intervall mit den Effektivwerten ohne Gleichanteil vergleicht, die in mehreren aufeinanderfolgenden Intervallen, die auf das bestimmte Intervall folgen, geschätzt werden.

11. Verfahren nach Anspruch 10, bei dem man davon ausgeht, dass der Schutzschalter (8) zum Zeitpunkt eines Intervalls N geöffnet ist, wenn, für K = 1 bis M,

$$\frac{U_{N+K+1}}{U_N} < (100\text{-}X)\%,$$

wobei K und M positive ganze Zahlen sind, X eine positive Zahl ist, die kleiner oder gleich 100 ist, und wobei $U_{N+K+1}$ und $U_N$ die Effektivwerte ohne Gleichanteil des Messsignals über die Intervalle N+K+1 und N sind.

12. Verfahren nach Anspruch 10, bei dem man davon ausgeht, dass der Schutzschalter zum Zeitpunkt des Intervalls N geöffnet ist, wenn für K = 1 bis M,

$$U_N\text{-}U_{N+K+1} > Y$$

wobei K und M positive ganze Zahlen sind, Y ein vorbestimmter Spannungswert ist, und wobei $U_{N+K+1}$ und $U_N$ die Effektivwerte ohne Gleichanteil des Messsignals über die Intervalle N+K+1 und N sind.

13. Verfahren nach Anspruch 9, bei dem, wenn der Effektivwert ohne Gleichanteil, der über eine bestimmte Anzahl von Intervallen geschätzt wird, kleiner ist als ein erster vorbestimmter Schwellwert (S1), man den vierten Verarbeitungsschritt durch einen fünften Verarbeitungsschritt ersetzt, während dessen man davon ausgeht, dass der Schutzschalter geöffnet ist, wenn für ein gegebenes Intervall der Gleichanteil des Messsignals kleiner als ein zweiter vorbestimmter Schwellwert (S2) ist.

14. Verfahren nach Anspruch 9, bei dem, wenn der Effektivwert ohne Gleichanteil, der über eine bestimmte Anzahl von Intervallen geschätzt wird, kleiner als ein erster vorbestimmter Schwellwert (S1) ist, man den vierten Verarbeitungsschritt durch einen fünften Verarbeitungsschritt ersetzt, während dessen man davon ausgeht, dass der Schutzschalter geöffnet ist, wenn für ein bestimmtes Intervall,

$$\frac{Max(V_k)+Min(V_k)}{2} < S3$$

wobei k eine positive ganze Zahl ist, wobei die Werte $V_k$ die Werte der Abtastungen des Messsignals in dem bestimmten Intervall sind, und wobei S3 ein dritter vorbestimmter Schwellwert ist.

15. Verfahren nach einem der Ansprüche 13 oder 14, bei dem man den fünften Verarbeitungsschritt nicht aktiviert, wenn der Effektivwert des Messsignals größer als ein vorbestimmter vierter Schwellwert (S4) ist.

16. Verfahren nach einem der Ansprüche 9 bis 15, bei dem, für den Fall, in dem das Trennrelais (13) nach einer Erfassung einer Überleistung geöffnet wurde, das Trennrelais nach einer bestimmten programmierbaren Zeitverzögerungsdauer erneut geschlossen wird, während der die Überleistung nicht mehr erfasst wird, selbst wenn ein Öffnen des Schutzschalters der Anlage nicht erfasst worden ist.

**Claims**

1. An electrical energy meter (1) for measuring a phase current (Icons) flowing in a phase conductor (5) and consumed under a phase voltage (Vnet) by a destination installation (4) situated downstream from the meter, the meter having a measurement stage (2) comprising a phase current sensor (9) connected in series with a cut-off relay (13), two series-connected measurement impedances (Z, R) connected in parallel with the sensor (9) and the relay (13), and measurement means (14) for measuring the electrical potential between the measurement impedances (Z, R), the two measurement impedances (Z, R) being positioned in such a manner that a first impedance (Z) is connected to the phase conductor (5) upstream from the sensor (9) and the relay (13), and the second impedance (R) is connected to the phase conductor (5) downstream from the sensor (9) and the relay (13), the meter being **characterized in that** the measurement stage (2) further includes an additional voltage source (Vadd) connected in series with the measurement impedances (Z, R).

2. An electrical energy meter (1) according to claim 1, wherein the additional voltage source (Vadd) is positioned between the first measurement impedance (Z) and the phase conductor (5) upstream from the sensor (9) and the relay (13).

3. An electrical energy meter (1) according to claim 1, wherein the first measurement impedance (Z) is nonlinear.

4. An electrical energy meter (1) according to claim 3, wherein the first measurement impedance (Z) comprises a first resistor (Zmax) and a first diode (15) connected in parallel with the first resistor (Zmax).

5. An electrical energy meter (1) according to claim 4, wherein the first measurement impedance also includes a second diode (15) connected in anti-parallel with the first diode (15).

6. An electrical energy meter (1) according to claim 4, wherein the first measurement impedance (Z) also includes a second resistor (Zmin) connected in series with the first resistor (Zmax).

7. An electrical energy meter (1) according to claim 1, wherein the measurement stage (2) also includes a capacitor (Cap) having one plate connected to the two measurement impedances (Z, R) at a point between them, and another plate connected to electrical ground (16).

8. An electrical energy meter (1) according to claim 1, wherein the measurement stage (2) also includes a processor means (3) arranged, as a function of measurements provided by the measurement means (14), to detect opening or closing of a circuit breaker (8) of the destination installation (4) when the cut-off relay (13) is open.

9. A method of detecting whether the circuit breaker (8) of the destination installation (4) is in an open or closed state by using an electrical energy meter according to any preceding claim, the method comprising:

   • a measuring step during which the electric potential between the measurement impedances (Z, R) is measured so as to obtain a sampled digital measurement signal representative of this electric potential;
   • a first processing step during which a DC component ($U_c$) of the measurement signal is estimated over intervals of predetermined duration corresponding to a certain number of samples of the measurement signal;
   • a second processing step, during which a root mean square value ($U_{rms}$) of the measurement signal is estimated over the intervals;
   • a third processing step, during which a non-DC root mean square value (U) of the measurement signal is estimated over the intervals; and
   • a fourth measuring step, in which it is determined whether the circuit breaker is open or closed on the basis of the non-DC root mean square value (U) of the measurement signal.

10. A method according to claim 9, wherein it is determined whether the circuit breaker is open or closed at a certain moment corresponding to a certain interval by comparing the non-DC rms value of the measurement signal over the certain interval with the non-DC rms values estimated in a plurality of successive intervals following the certain interval.

11. A method according to claim 10, wherein it is considered that the circuit breaker (8) is open at the moment of an interval N if, for K = 1 to M:

$$\frac{U_{N+K+1}}{U_N} < (100 - X)\%,$$

where K and M are positive integers, X is a positive number less than or equal to 100, and where $U_{N+K+1}$ and $U_N$ are the non-DC rms values of the measurement signal over the intervals N+K+1 and N.

12. A method according to claim 10, wherein it is considered that the circuit breaker is open at the moment of the interval N if, for K = 1 to M:

$$U_N - U_{N+K+1} > Y$$

where K and M are positive integers, Y is a predetermined voltage value, and where $U_{N+K+1}$ and $U_N$ are the non-DC rms values of the measurement signal over the intervals N+K+1 and N.

13. A method according to claim 9, wherein if the non-DC rms value estimated over a certain number of intervals is less than a first predetermined threshold (S1), then the fourth processing step is replaced by a fifth processing step during which it is considered that the circuit breaker is open if, for a given interval, the DC component Uc of the measurement signal is less than a second predetermined threshold (S2).

14. A method according to claim 9, wherein if the non-DC rms value estimated over a certain number of intervals is less than a first predetermined threshold (S1), then the fourth processing step is replaced by a fifth processing step during which it is considered that the circuit breaker is open if, for a certain interval:

$$\frac{Max(V_k) + Min(V_k)}{2} < S3$$

where k is a positive integer, where the values $V_k$ are the values of samples of the measurement signal in the certain interval, and where S3 is a third predetermined threshold.

15. A method according to claim 13 or claim 14, wherein the fifth processing step is not activated if the rms value of the measurement signal is greater than a fourth predetermined threshold (S4).

16. A method according to any one of claims 9 to 15, wherein in the event of the cut-off relay (13) being opened as a result of detecting excess power, the cut-off relay is reclosed after a certain programmable time delay during which the excess power is no longer detected, even if it is not detected that the circuit breaker of the installation has been opened.

Fig.1

Fig.2

**EP 2 820 433 B1**

## RÉFÉRENCES CITÉES DANS LA DESCRIPTION

**Documents brevets cités dans la description**

- WO 2010149921 A

- US 5488565 A